# EUROPÄISCHE PATENTSCHRIFT

(11) **EP 2 517 247 B1**
(45) Veröffentlichungstag und Bekanntmachung des Hinweises auf die Patenterteilung: **26.09.2018**
(21) Anmeldenummer: 10796386.0
(22) Anmeldetag: 21.12.2010
(51) Int. Cl.: H01L 27/146, H01L 23/00, H05K 3/34, H01L 31/101, H01L 31/18, H01L 31/0203

(54) **VERFAHREN ZUM HERSTELLEN EINES INFRAROTLICHTDETEKTORS**
METHOD FOR PRODUCING AN INFRARED LIGHT DETECTOR
PROCÉDÉ DE PRODUCTION D'UN DÉTECTEUR DE LUMIÈRE INFRAROUGE

(30) Priorität: 23.12.2009 DE 102009060217
(43) Veröffentlichungstag der Anmeldung: 31.10.2012
(73) Patentinhaber: Pyreos Ltd., EH9 3JF Edinburgh (GB)
(72) Erfinder: LAIRD, Ron, North Lanarkshire ML6 7TQ (GB); FREEBORN, Scott, Edinburgh EH11 1RQ (GB); STEWART, Archie, Shaw, Doune FK16 6AX (GB)
(74) Vertreter: Fischer, Ernst
(86) Internationale Anmeldenummer: PCT/EP2010/070372
(87) Internationale Veröffentlichungsnummer: WO 2011/076788

(56) Entgegenhaltungen:
- WO-A1-91/11833
- JP-A- 8 204 166
- US-A- 5 024 372
- US-A- 5 313 021
- US-A- 5 406 701
- US-A1- 2003 057 426
- US-A1- 2006 079 009

## Beschreibung

Die Erfindung betrifft ein Verfahren zum Herstellen eines Infrarotlichtdetektors.

Ein herkömmlicher Infrarotlichtdetektor weist eine Leiterplatte und an deren Oberseite eine Mehrzahl an Sensorchips auf, die zum Detektieren von Infrarotlicht eingerichtet sind. Damit die Sensorchips mit unterschiedlichen Wellenlängenbändern von Infrarotlicht bestrahlt werden können, sind den Sensorchips entsprechend ausgebildete Infrarotlichtfilter vorgeschaltet, die beispielsweise in einem Gehäuse des Infrarotlichtdetektors integriert sind. Das Gehäuse ist von einem topfförmigen Gehäusedeckel und einem dieses abschließenden Gehäuseboden gebildet, wobei im Inneren des Gehäuses die Leiterplatte mit den Sensorchips angeordnet ist. Die Sensorchips sind ihren zugeordneten Infrarotlichtfiltern zugewandt platziert und von einer auf der Leiterplatte angebrachten elektronischen Schaltung betrieben. Die in den Sensorchips generierten elektrischen Signale sind von an die Leiterplatte angeschlossenen Anschlussstiften abgreifbar, wobei die Anschlussstifte von der Leiterplatte durch den Gehäuseboden nach außerhalb des Gehäuses geführt sind. Zum elektrischen Verbinden der Anschlussstifte mit der auf der Leiterplatte sich befindlichen elektrischen Schaltung sind die Anschlussstifte durch Löcher in der Leiterplatte geführt. Durch die Anwesenheit der Löcher in der Leiterplatte ist allerdings der zur Verfügung stehende Platz zum Anordnen der Sensorchips und der Schaltung begrenzt, wodurch die Bauteildichte des Infrarotlichtdetektors gering ist.

Damit die Sensorchips eine hohe Messgenauigkeit haben ist es insbesondere notwendig, dass die Infrarotlichtfilter eine hohe Parallelität zu ihren Sensorchips haben. Dadurch, dass die Sensorchips auf der Leiterplatte und die Infrarotlichtfilter in dem Gehäusedeckel integriert angeordnet sind, kommt es schließlich auf eine ausreichende Parallelität zwischen der Leiterplatte und dem Gehäusedeckel an. Hierfür sind aufwändige Maßnahmen bei der Herstellung des Infrarotlichtdetektors notwendig.

In US 5 406 701 A, US 2003/057426 A1, US 5 313 021 A und JP 8 204166 A sind Verfahren um Herstellen von Lötverbindungen an elektronischen Bauteilen und deren Ausrichtungen zueinander beschrieben.

Dokument WO 91/11833 offenbart eine Chip-Verbindung wobei ein erstes Substrat eine Anzahl von Lötmittel enthaltenden Mulden umfasst. Das Lötmittel in jeder der Mulden ist in Lötkontakt mit einem entsprechenden aus einer Anzahl von leitenden Stiften. Die Stifte erstrecken sich von einer flachen Oberfläche eines zweiten Substrats. Die Chip-Verbindung umfasst eine auf dem zweiten Substrat angebrachte dielektrische Schicht.

Aufgabe der Erfindung ist es ein Verfahren zum Herstellen eines Infrarotlichtdetektors zu schaffen, wobei der Infrarotlichtdetektor eine hohe Baudichte und eine hohe Messgenauigkeit hat.

Das erfindungsgemäße Verfahren zum Herstellen eines Infrarotlichtdetektors ist in dem unabhängigen Patentanspruch 1 definiert.

Weiterbildungen des Verfahrens finden sich jeweils in den nachgeordneten abhängigen Patentansprüchen 2 - 5.

Der mit dem erfindungsgemäßen Verfahren hergestellte Infrarotlichtdetektor weist die Leiterplatte auf, deren

Oberseite frei von den Mulden ist, so dass die gesamte Oberseite der Leiterplatte für das Unterbringen der Sensorchips und von elektronischen Schaltungen zur Verfügung steht. Verglichen mit einer Leiterplatte eines mit einem herkömmlichen Verfahren hergestellten Infrarotlichtdetektors, bei dem die Leiterplatte etwa mit Durchgangslöchern für Anschlussstifte versehen ist, ist der von der Oberfläche bereitgestellte Platz für die Sensorchips und den elektronischen Schaltungen groß. Somit ist mit dem erfindungsgemäß hergestellten Infrarotlichtdetektor eine hohe Baudichte erzielbar, wodurch die geometrischen Abmaße des erfindungsgemäß hergestellten Infrarotlichtdetektors geringer sind als die geometrischen Abmaße des herkömmlich hergestellten Infrarotlichtdetektors. Außerdem wird mit dem erfindungsgemäßen Verfahren eine hohe Positioniergenauigkeit zwischen den Anschlussstiften und der Leiterplatte erzielt.

Bevorzugtermaßen wird die Leiterplatte so positioniert, dass mindestens einer der Anschlussstifte mit seinem Längsende mit dem Muldengrund der dem Anschlussstift zugeordneten Mulde in Berührkontakt steht. Das Verflüssigen der Lotpastenkörper wird bevorzugt durch Erhitzen der Lotpastenkörper und das Verfestigen der Lotpastenkörper durch Abkühlen der Lotpastenkörper bewerkstelligt. Ferner ist es erfindungsgemäß, dass beim Verfahren zum Herstellen des Infrarotlichtdetektors ein parallel zur Horizontalebene angeordneter Gehäuseboden bereitgestellt wird, in dem für jeden der Anschlussstifte eine Durchgangspassung vorgesehen ist, wobei sich durch jede der Durchgangspassungen der ihr zugeordnete Anschlussstift erstreckt, so dass von dem Gehäuseboden die Anschlussstifte in den Durchgangspassungen in Position gehalten werden. Dadurch wird vorteilhaft eine hohe Parallelität zwischen dem Gehäuseboden und der Leiterplatte erzielt.

Weitere bevorzugte Schritte des Verfahrens zum Herstellen des Infrarotlichtdetektors sind: Bereitstellen eines topfförmigen Gehäusedeckels; Befestigen des Gehäusedeckels mit dem Gehäuseboden, so dass von dem Gehäuseboden und dem Gehäusedeckel ein Gehäuse gebildet wird, in dem die Leiterplatte untergebracht wird. Dadurch, dass eine hohe Parallelität zwischen dem Gehäuseboden und der Leiterplatte erzielt ist, ist ebenfalls eine hohe Parallelität zwischen der Leiterplatte und dem Gehäusedeckel erreicht.

Weitere bevorzugte Schritte sind: Anbringen von mindestens einem Sensorchip auf einer der Unterseite abgewandten Oberseite der Leiterplatte; Vorsehen eines Infrarotlichtfilters in dem Gehäusedeckel, der dem Sensorchip für dessen Bestrahlung mit Infrarotlicht von außerhalb des Infrarotlichtdetektors zugeordnet ist. Somit wird mit dem erfindungsgemäßen Herstellungsverfahren eine hohe Parallelität zwischen den Sensoren und ihren zugeordneten Infrarotlichtfiltern erzielt, da eine exakte Positionierung der Leiterplatte mit den Sensorchips via die Anschlussstifte, den Gehäuseboden und den Gehäusedeckel zu den Infrarotlichtfiltern erreicht ist. Dadurch hat der mit dem erfindungsgemäßen Verfahren hergestellte Infrarotlichtdetektor eine hohe Messgenauigkeit.

Im Folgenden wird eine bevorzugte Ausführungsform eines mit dem erfindungsgemäßen Verfahren hergestellten Infrarotlichtdetektors anhand der beigefügten schematischen Zeichnungen erläutert. Es zeigen:
Figur 1 einen Querschnitt der Ausführungsform des Infrarotlichtdetektors,
Figur 2 Schnitt I aus Figur 1, und
Figur 3 Detail II aus Figur 1.

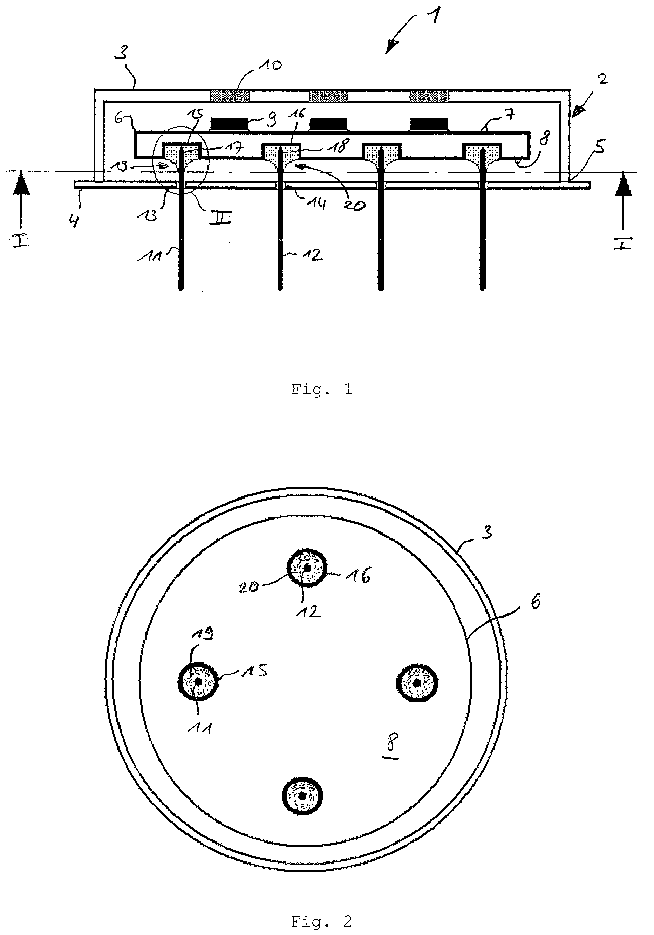

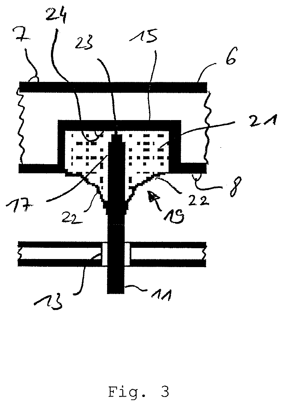

Wie es aus Figuren 1 bis 3 ersichtlich ist, weist ein erfindungsgemäß hergestellter Infrarotlichtdetektor 1 ein Gehäuse 2 auf, das von einem Gehäusedeckel 3 und einem Gehäuseboden 4 gebildet ist. Der Gehäusedeckel 3 ist topfförmig ausgebildet und ist mit seinem Außenrand auf dem Gehäuseboden 4 mit Hilfe einer gebondeten Befestigung 5 befestigt. Von dem Gehäusedeckel 3 und dem Gehäuseboden 4 wird ein Innenraum des Gehäuses 2 definiert, in dem eine Leiterplatte 6 angeordnet ist. Die Leiterplatte 6 weist eine Leiterplattenoberseite 7 und eine Leiterplattenunterseite 8 auf, wobei die Leiterplattenoberseite 7 in Figur 1 oben und die Leiterplattenunterseite 8 in Figur 1 unten angeordnet sind. Auf der Leiterplattenoberseite 7 sind eine Mehrzahl, gemäß Figur 2 vier, Sensorchips 9 angebracht. Oberhalb eines jeden der Sensorchips 9 ist jeweils ein Infrarotlichtfilter 10 vorgesehen, wobei jeder der Infrarotlichtfilter 10 in dem Gehäusedeckel 3 integriert ist. An der Leiterplattenunterseite 8 ist eine Mehrzahl an Anschlussstiften 11, 12 vorgesehen, die mit einer elektronischen Schaltung (nicht gezeigt) in der Leiterplatte 6 elektrisch verbunden sind. Die Anschlussstifte 11, 12 erstrecken sich senkrecht und durch den Gehäuseboden 4 hindurch, wobei für jeden der Anschlussstifte 11, 12 in dem Gehäuseboden 4 eine Passung 13, 14 vorgesehen ist.

An der Leiterplattenunterseite 8 ist für jeden Anschlussstift 11, 12 eine Mulde 15, 16 vorgesehen in die jeweils der dazugehörige Anschlussstift 11, 12 mit seinem Längsende 17, 18 ragt. In den Mulden 15, 16 sind die Anschlussstifte 11, 12 mit Lotbefestigungen 19, 20 befestigt und mit der elektronischen Schaltung elektrisch leitend verbunden. Die Lotbefestigungen 19, 20 sind jeweils von einem Lotkörper 21 gebildet, der in den Mulden 15, 16 aus Lotpaste hergestellt ist. Beim Herstellen der Lotbefestigungen 19, 20 wurden die Lotkörper 21 verflüssigt, wobei sich jeweils um den Anschlussstift 11, 12 eine kegeloberflächenartige Lotkörperoberfläche 22 ausgebildet hat. Die Längsenden 17, 18 der Anschlussstifte 11, 12 weisen jeweils eine Spitze 23 auf, die an einen Muldengrund 24 anstoßen.

Beim Herstellen des Infrarotlichtdetektors 1 sind die folgenden Schritte durchzuführen: Es ist die Leiterplatte 6 bereitzustellen, in die die Mulden 15, 16 beispielsweise durch Ätzen herzustellen sind. Auf der Leiterplattenoberseite 7 sind die Sensorchips 9 und die elektronische Schaltung anzubringen. Ferner sind die Anschlussstifte 11, 12 parallel zueinander anzuordnen und zu halten, wobei die Längsenden 17, 18 der Anschlussstifte 11, 12 in einer Horizontalebene angeordnet sind und die Anschlussstifte 11, 12 senkrecht zur Horizontalebene sich erstrecken. Ferner wird der Gehäuseboden 4 mit seinen Passungen 13, 14 bereitgestellt, wobei in jede der Passungen 13, 14 jeweils einer der Anschlussstifte 11, 12 eingesetzt und dadurch an Ort und Stelle gehalten ist. Dadurch sind die Anschlussstifte 11, 12 zueinander parallel und senkrecht zu dem Gehäuseboden 4 stabil gehalten.

Die Anschlussstifte 11, 12 und die Mulden 15, 16 sind in ihren Lagen so aufeinander abgestimmt, dass für jeden der Anschlussstifte 11, 12 eine der Mulden 15, 16 zugeordnet ist. Die Mulden 15, 16 sind gleichförmig auszubilden, beispielsweise durch Ätzen. Ferner sind die Mulden mit einer Lötpaste zu befüllen, wobei in jeder der Mulden 15, 16 die gleiche Lotpastenmenge zu bringen ist. Dann wird die Leiterplatte 6 oberhalb der Anschlussstifte 11, 12 positioniert, so dass jeder der Anschlussstifte 11, 12 mit seinen Längsenden 17, 18 in den entsprechenden Lotpastenkörper 21 taucht. Danach werden die Lotpastenkörper 21 beispielsweise in einem Ofen auf 300°C erwärmt, so dass die Lotpastenkörper 21 sich verflüssigen. Aufgrund der Oberflächenspannung der verflüssigten Lotpasten und des Eigengewichts der Leiterplatte 6 wird diese selbst zentriert zu den Anschlussstiften 11, 12 ausgerichtet. Dadurch wird die Leiterplatte 6 in eine waagrechte Lage gebracht, in der die Anschlussstifte 11, 12 senkrecht zur Leiterplatte 6 sich erstrecken.

Sodann werden die Lotpastenkörper 21 wieder abgekühlt, wodurch sich die Lotpastenkörper 21 verfestigen und eine mechanisch feste Verbindung in den Mulden 15, 16 zwischen der Leiterplatte 6 und den Anschlussstiften 11, 12 ausgebildet wird sowie eine elektrisch leitende Verbindungen zwischen den Anschlussstiften 11, 12 und der elektronischen Schaltung via die Lotpastenkörpern 21. Der Gehäusedeckel 3 wird auf den Gehäuseboden 4 über die Leiterplatte 6 gestülpt und die gebondete Befestigung 5 ausgebildet.

Die Anschlussstifte 11, 12 sind in ihren Passungen 13, 14 stabil und genau in dem Gehäuseboden 4 gehalten. Die Leiterplatte 6 ist mit den Lotbefestigungen 19, 20 in den Mulden 15, 16 hervorgerufen durch die Oberflächenspannung in den Lotpastenkörpern 21 und dem Eigengewicht der Leiterplatte 6 selbst zentriert präzise zu den Anschlussstiften 11, 12 und somit zu dem Gehäuseboden 4 angeordnet. Der Gehäusedeckel 3 ist auf dem Gehäuseboden 4 aufgesetzt, so dass die in den Gehäusedeckel 3 integrierten Infrarotlichtfilter 10 präzise gegenüber den Sensorchips 9 angeordnet sind. Dadurch ist eine hohe Parallelität zwischen den Sensorchips 9 und ihren zugeordneten Infrarotlichtfiltern 10 erreicht, wodurch die Messgenauigkeit des Infrarotlichtdetektors 1 hoch ist. Ferner ist die gesamte Leiterplattenoberfläche 7 der Leiterplatte 6 für den Verbau der Sensorchips 9 und der elektronischen Schaltung bereitgestellt, wodurch der Infrarotlichtdetektor 1 eine hohe Baudichte hat.

### Bezugszeichenliste

- 1: Infrarotlichtdetektor
- 2: Gehäuse
- 3: Gehäusedeckel
- 4: Gehäuseboden
- 5: gebondete Befestigung
- 6: Leiterplatte
- 7: Leiterplattenoberseite
- 8: Leiterplattenunterseite
- 9: Sensorchip
- 10: Infrarotlichtfenster
- 11: erster Anschlussstift
- 12: zweiter Anschlussstift
- 13: erste Durchgangspassung
- 14: zweite Durchgangspassung
- 15: erste Mulde
- 16: zweite Mulde
- 17: Längsende des ersten Pins
- 18: Längsende des zweiten Pins
- 19: erste Lotbefestigung
- 20: zweite Lotbefestigung
- 21: Lotpastenkörper
- 22: Lotpastenkörperoberfläche
- 23: Anschlussstiftspitze
- 24: Muldengrund

## Patentansprüche

1. Verfahren zum Herstellen eines Infrarotlichtdetektors (1), mit den Schritten:
- Bereitstellen einer Mehrzahl an Anschlussstiften (11, 12), die parallel zueinander und mit ihren einen Längsenden (17, 18) in einer Horizontalebene angeordnet gehalten sind, wobei die Anschlussstifte (11, 12) von der Horizontalebene sich nach unten erstrecken, und einer Leiterplatte (6) mit einer ebenen Unterseite (8), in der für jeden der Anschlussstifte (11, 12) eine Mulde (15, 16) vorgesehen ist, die in dem Bereich der Leiterplatte (6) angeordnet ist, an den der der Mulde (15, 16) zugeordnete Anschlussstift (11, 12) anzubringen ist, wobei die Mulden (15, 16) jeweils dieselbe Form haben, wobei ein parallel zur Horizontalebene angeordneter Gehäuseboden (4) bereitgestellt wird, in dem für jeden der Anschlussstifte (11, 12) eine Durchgangspassung (13, 14) vorgesehen ist, wobei sich durch jede der Durchgangspassungen (13, 14) der ihr zugeordnete Anschlussstift (11, 12) erstreckt, so dass von dem Gehäuseboden (4) die Anschlussstifte (11, 12) in den Durchgangspassungen (13, 14) in Position gehalten werden;
- Befüllen der Mulden (15, 16) mit einer Lotpaste, so dass in jeder der Mulden (15, 16) sich ein Lotpastenkörper (21) mit der gleichen Lotpastenmenge befindet;
- Positionieren der Leiterplatte (6) oberhalb der Anschlussstifte (11, 12), so dass jeder der Anschlussstifte (11, 12) mit seinem Längsende (17, 18) sich in der ihm zugeordneten Mulde (15, 16) erstreckt und in den in der jeweiligen Mulde (15, 16) sich befindlichen Lotpastenkörper (21) taucht;
- Verflüssigen der Lotpastenkörper (21), wobei sich jeweils um den Anschlussstift (11, 12) eine kegeloberflächenartige Lotpastenkörperoberfläche (22) ausbildet, so dass elektrisch leitende Verbindungen zwischen den Anschlussstiften (11, 12) und den Lotpastenkörpern (21) ausgebildet werden sowie auf Grund der Oberflächenspannung in den Lotpastenkörpern (21) und dem Eigengewicht der Leiterplatte (6) die Unterseite (8) der Leiterplatte (6) parallel zur Horizontalebene ausrichtet wird;
- Verfestigen der Lotpastenkörper (21), so dass mit den Lotpastenkörpern (21) mechanisch feste Verbindungen zwischen der Leiterplatte (6) und den Anschlussstiften (11, 12) ausgebildet werden und die Ausrichtung der Unterseite (8) der Leiterplatte (6) parallel zur Horizontalebene fixiert wird;
- Anbringen von mindestens einem Sensorchip (9) auf einer der Unterseite (8) abgewandten Oberseite (7) der Leiterplatte (6).

2. Verfahren gemäß Anspruch 1, wobei die Leiterplatte (6) so positioniert wird, dass mindestens einer der Anschlussstifte (11, 12) mit seinem Längsende mit dem Muldengrund (24) der dem Anschlussstift (11, 12) zugeordneten Mulde (15, 16) in Berührkontakt steht.

3. Verfahren gemäß Anspruch 1 oder 2, wobei das Verflüssigen der Lotpastenkörper (21) durch Erhitzen der Lotpastenkörper (21) bewerkstelligt wird und das Verfestigen der Lotpastenkörper (21) durch Abkühlen der Lotpastenkörper (21) bewerkstelligt wird.

4. Verfahren gemäß einem der Ansprüche 1 bis 3, mit den Schritten:
- Bereitstellen eines topfförmigen Gehäusedeckels (3);
- Befestigen des Gehäusedeckels (3) auf dem Gehäuseboden (4), so dass von dem Gehäuseboden (4) und dem Gehäusedeckel (3) ein Gehäuse (2) gebildet wird, in dem die Leiterplatte (6) untergebracht wird.

5. Verfahren gemäß Anspruch 4, mit dem Schritt:
- Vorsehen eines Infrarotlichtfilters (10) in dem Gehäusedeckel (3), der dem Sensorchip (9) für dessen Bestrahlung mit Infrarotlicht von Außerhalb des Infrarotlichtdetektors (1) zugeordnet ist.

## Claims

1. A method for producing an infrared light detector (1), wherein the method comprises the steps:
- providing a circuit board (6) and a plurality of connection pins (11, 12) which are arranged parallel to one another, and wherein each of the plurality of connection pins (11, 12) are arranged with one of the longitudinal ends (17, 18) of the connection pins (11, 12) in a horizontal plane, wherein each of the connection pins (11, 12) extend downward from the horizontal plane, and wherein the circuit board (6) has a flat bottom side (8) in that a recess (15, 16) is intended for each of the connection pins (11, 12), wherein the recess (15, 16) is arranged in the portion of the circuit board (6), wherein on the portion of the circuit board (6) the connection pin (11, 12) corresponding to the recess (15, 16) is to be attached, wherein the recesses (15, 16) respectively have the same shape, wherein a housing floor (4) is provided that is arranged parallel with respect to the horizontal plane, wherein for each of the connection pins (11, 12) a passage (13, 14) is intended in the housing floor (4), wherein the connection pin (11, 12) that corresponds to the respective passage (13, 14) extends through each of the passages (13, 14) so that the connection pins (11, 12) are held in position inside the passages (13, 14) by the housing floor (4);
- filling the recesses (15, 16) with a solder paste so that in each of the recesses (15, 16) a solder paste body (21) is located with the same solder paste amount;
- positioning the circuit board (6) above the connection pins (11, 12) so that the longitudinal end of each of the connection pins (11, 12) extends inside its respective recess (15, 16) and that the longitudinal end of each of the connection pins (11, 12) dips into the respective solder paste body (21) that is located in the respective recess (15, 16);
- liquefying the solder paste bodies (21), wherein a cone-surface-like solder paste body surface (22) is formed around the respective connection pin (11, 12) so that electrically conductive connections between the connection pins (11, 12) and the solder paste bodies (21) are formed as well as the bottom side (8) of the circuit board (6) is aligned in parallel with respect to the horizontal plane because of the surface tension inside the solder paste bodies (21) and the self-weight of the circuit board (6);
- solidifying the solder paste bodies (21) so that mechanically rigid connections between the circuit board (6) and the connection pins (11, 12) are formed with the solder paste bodies (21), and so that the orientation of the bottom side (8) of the circuit board (6) is fixed parallel with respect to the horizontal plane;
- attaching of at least one sensor chip (9) on a top side (7) of the circuit board (6), wherein the top side (7) is facing away from the bottom side (8).

2. Method according to claim 1, wherein the circuit board (6) is positioned so that the longitudinal end of at least one of the connection pins (11, 12) contacts the respective recess base (24) of the recess (15, 16) that corresponds to the connection pin (11, 12).

3. Method according to claim 1 or 2, wherein the liquefying of the solder paste bodies (21) is achieved by heating of the solder paste bodies (21) and wherein the solidifying of the solder paste bodies (21) is achieved by cooling down the solder paste bodies (21).

4. Method according to any one of the claims 1 to 3, wherein the method comprises the steps:
- providing of a cup-shaped housing cap (3);
- fastening of the housing cap (3) on the housing floor (4) so that a housing (2) is formed by the housing floor (4) and the housing cap (3), wherein the circuit board (6) is accommodated inside the housing (2).

5. Method according to claim 4, wherein the method comprises the step:
- intending of an infrared light filter (10) in the housing cap (3) that is assigned to the sensor chip (9) for irradiation thereof with infrared light from outside the infrared light detector (1).

## Revendications

1. Procédé pour fabriquer un détecteur de lumière infrarouge (1), comportant les étapes consistant à :
- fournir une pluralité de broches de connexion (11, 12) parallèles les unes aux autres et dont leurs premières extrémités longitudinales (17, 18) sont maintenues agencées dans un plan horizontal, dans lequel les broches de connexion (11, 12) s'étendent vers le bas à partir du plan horizontal, et une carte à circuit imprimé (6) ayant une face inférieure plate (8), dans laquelle un évidement (15, 16) est prévu pour chacune des boches de connexion (11, 12), lequel évidement est agencé dans la zone de la carte à circuit imprimé (6) sur laquelle la broche de connexion (11, 12) associée à l'évidement (15, 16) doit être fixée, dans lequel les évidements (15, 16) ont respectivement la même forme, dans lequel un corps de boîtier (4) agencé parallèlement au plan horizontal est fourni, dans lequel est prévu un passage (13, 14) pour chacune des broches de connexion (11, 12), dans lequel la broche de connexion (11, 12) associée à celui-ci s'étend à travers chacun des passages (13, 14), de sorte qu'à partir du corps de boîtier (4), les broches de connexion (11, 12) sont maintenues en position dans les passages (13, 14),
- remplir les évidements (13, 14) avec une pâte à souder de sorte qu'un corps de pâte à souder (21) ayant la même quantité de pâte à souder se trouve dans chacun des évidements (15, 16),
- positionner la carte à circuit imprimé (6) au-dessus des broches de connexion (11, 12), de sorte que chacune des broches de connexion (11, 12) s'étend avec son extrémité longitudinale (17, 18) dans l'évidement (15, 16) associé à celle-ci et plonge dans le corps de pâte à souder (21) se trouvant dans l'évidement (15, 16) respectif,
- liquéfier les corps de pâte à souder (21), dans lequel une surface de corps de pâte à souder (22) analogue à une surface conique se forme respectivement autour de la broche de connexion (11, 12), de sorte que des connexion électriquement conductrices sont formées entre les broches de connexion (11, 12) et les corps de pâte à souder (21) et en raison de la tension de surface dans les corps de pâte à souder (21) et du poids propre de la carte à circuit imprimé (6), la face inférieure (8) de la carte à circuit imprimé (6) est orientée parallèlement au plan horizontal,
- solidifier les corps de pâte à souder (21) de sorte que des connexions mécaniquement rigides avec les corps de pâte à souder (21) sont formées entre la carte à circuit imprimé (6) et les broches de connexion (11, 12), et l'orientation de la face inférieure (8) de la carte à circuit imprimé (6) est fixée ment au plan horizontal,
- appliquer au moins une puce de détection (9) sur une face supérieure (7) opposée à la face inférieure (8) de la carte à circuit imprimé (6).

2. Procédé selon la revendication 1, dans lequel la carte à circuit imprimé (6) est positionnée de sorte qu'au moins une des broches de connexion (11, 12) avec son extrémité longitudinale est en contact avec la base d'évidement (24) de l'évidement (15, 16) associé à la broche de connexion (11, 12).

3. Procédé selon la revendication 1 ou 2, dans lequel la liquéfaction des corps de pâte à souder (21) est réalisée en chauffant les corps de pâte à souder (21) et la solidification des corps de pâte à souder (21) est réalisée en refroidissant les corps de pâte à souder (21).

4. Procédé selon l'une des revendications 1 à 3, comportant les étapes consistant à :
- fournir un couvercle de boîtier (3) en forme de creuset,
- fixer le couvercle de boîtier (3) sur le corps de boîtier (4), de sorte qu'un boîtier (2) est formé à partir du corps de boîtier (4) et du couvercle de boîtier (3), boîtier dans lequel la carte à circuit imprimé (6) est reçue.

5. Procédé selon la revendication 4, comportant l'étape consistant à :
- prévoir un filtre de lumière infrarouge (10) dans le couvercle de boîtier (3), qui est associé à la puce de détection (9) pour soumettre celle-ci à un rayonnement avec une lumière infrarouge provenant de l'extérieur du détecteur de lumière infrarouge (1).
